## Europäisches Patentamt
## European Patent Office
## Office européen des brevets

(19)

(11) Publication number: **0 053 501**
A2

(12) # EUROPEAN PATENT APPLICATION

(21) Application number: 81305636.3

(22) Date of filing: **27.11.81**

(51) Int. Cl.³: **H 05 K 3/30**, G 06 F 15/46

(30) Priority: **28.11.80 GB 8038309**

(43) Date of publication of application: **09.06.82**
Bulletin 82/23

(84) Designated Contracting States: **AT BE CH DE FR GB IT LI LU NL SE**

(71) Applicant: **MARKRIS ELECTRONICS LIMITED, 1 Queensway, New Milton Hampshire (GB)**

(72) Inventor: **Noble, Peter John Wellesley, 7 Trent Close, Tolpuddle Dorchester Dorset (GB)**

(74) Representative: **Meddle, Alan Leonard et al, FORRESTER & BOEHMERT Widenmayerstrasse 4/I, D-8000 Munchen 22 (DE)**

(54) **Indicating the required location of a component to be assembled on a workpiece.**

(57) An apparatus for indicating to an operative the required location of a component to be assembled on a printed circuit board comprises a projection unit having a projector (45) for optically projecting a sequence of component images formed in a liquid crystal unit onto a circuit board placed on an assembly surface (39) of a bench (2). The liquid crystal unit is associated with light producing and condensing means to illuminate the image formed in the liquid crystal unit, which unit comprises an array of liquid crystals and associated scan electronics to address a given crystal. A programmer (30) is provided for establishing the sequence of component images for a given circuit board and is connectable to a microprocessor of the projection unit. Using a keyboard (24) of the programmer (30) the projection unit (45) is instructed to project a selected component image stored in an electronic pattern library of the projection unit onto the circuit board. The image can then be moved to the required position and the identity of the component image and its position stored in a memory of the projection unit together with instructions for a component dispensing device (40). A complete assembly sequence may be stored in the memory and then recorded on a program record (26) for replay by the projection unit to project the sequence of component images onto a circuit board to be assembled and at the same time dispense each component to the operative in synchronism with the corresponding projected image.

"Indicating the required location of a component to be assembled on a workpiece"

THIS INVENTION relates to an apparatus and method for indicating to an operative the required location of a component on a workpiece, the invention finding particular application in the assembling of electrical components on a printed circuit board.

In the assembly of components on a printed circuit board, it is known to provide apparatus for visually and sequentially indicating to an operative the required positions of the components on the board, such apparatus usually being associated with means to dispense to the operative the particular component to be assembled at the indicated location. The use of such apparatus significantly improves the accuracy with which the components are assembled on the board, whilst also decreasing the time required to assemble a given board. Such apparatus can also ensure that the components are assembled on the board in a predetermined optimum order.

It has already been proposed to illuminate a required component position on the printed circuit board by means of a fibre optic head mounted on a positioning device behind the board so as to illuminate the lead holes corresponding to the component to be assembled. However, such so-called rear projection systems require extremely careful alignment because of the effects of optical parallax. Such rear projection systems also suffer from the drawback and they cannot be used to check an assembled board because clearly, after assembly, the lead holes are blocked.

So-called front projection systems, providing a visual indication of the required component position on the front of the printed circuit board, are also known and are easier to use than rear projection systems. One known front projection system employs a light spot which is projected onto the board and oscillated between the two ends of the required component location. The main disadvantage with the light spot system is that only one component position can be indicated at a time.

Another known front projection system involves projecting onto the printed circuit board the image of a photographic film frame on which a representation of a component is recorded at the required location. Clearly, the film frame can be recorded with the position of more than one component of the same type and value to be assembled at the same time and useful assembly instructions can also be recorded on the film frame. A complete assembly sequence is easily stored on a film loop, which can also be used to check the positioning of the components on the printed circuit board after assembly. However, the flexibility of this system is limited by the amount of time required to plan and record this film loop and the possibility of damage during use or handling of the film.

According to one aspect of the present invention, there is provided apparatus for visually indicating to an operative the required location of a component to be assembled on a workpiece, which apparatus includes a projection unit comprising a liquid crystal unit, means for generating a video signal for the liquid crystal unit to form therein a representation of the component at a position corresponding to the required location of the component on the workpiece surface and optical means for projecting an image of the representation formed in the liquid crystal unit on to the surface of the workpiece.

In one form of the invention, the signal-generating means comprises a pattern library for storing patterns which represent various kinds of component, a programme memory for storing data defining a sequence of component patterns and positions, and a processor, such as a microprocessor, connected to the pattern library and the programme memory for generating the required video signal from the stored pattern and programme data.

Desirably the liquid crystal unit is associated with light producing and condensing means to illuminate the image formed in the liquid crystal unit, which unit usually comprises a grid of liquid crystals and associated scan electronics to address a given crystal.

0053501

Advantageously, the projection unit also provides an electrical control signal for controlling a component dispensing device to dispense to the operative the particular component to be assembled at the location indicated by the component representation in the projected image.

Apparatus embodying the invention may include a programming unit for programming the projection with data relating to a desired assembly sequence, which programming unit comprises means, such as a keyboard, for supplying alpha-numeric data to the signal generating means to cause a desired component pattern to be formed in the liquid crystal unit and position control means, such as a joystick control or direction cursors formed by keys on a keyboard, for delivering a positioning signal to the signal generating means for varying the position of the displayed pattern in the liquid crystal unit to bring the pattern into a position corresponding to the desired location on the workpiece surface.

The programming unit may comprise recording and playback means for storing the programme generated by the programming unit, for example a cassette tape machine or alternatively a solid state memory may be used for permanent or semi-permanent storage of the programme. If desired, a printer may also be provided in the programming unit to provide a hard copy of the generated programme.

Preferably, the programming unit is detachable from the projection unit, so that a single programming unit may be used with a plurality of projection units.

According to another aspect of the present invention, there is provided a method of visually indicating to an operative the required location of a component to be assembled on a workpiece, which method comprises generating a video signal for a liquid crystal unit for form therein a representation of the component at a position corresponding to the required location of the component on a surface of the workpiece, and optically projecting an image of the representation formed in the liquid crystal unit onto the surface of the workpiece.

In order that the invention may be readily understood, an embodiment thereof will now be described, by way of example, with reference to the accompanying drawings, in which:

FIGURE 1 shows an operative seated at a workbench used to assemble electrical components on a printed circuit board and provided with apparatus embodying the invention;

FIGURE 2 is a schematic diagram of the apparatus embodying the invention;

FIGURE 3 illustrates an example of the information recorded and optically projected onto the printed circuit board by the apparatus;

FIGURE 4 diagrammatically illustrates an optical system of the apparatus for projecting the component pattern on to a printed circuit board; and

FIGURE 5 shows in detail a modified form of the workbench of Figure 1 provided with apparatus embodying the invention together with a separate programming unit.

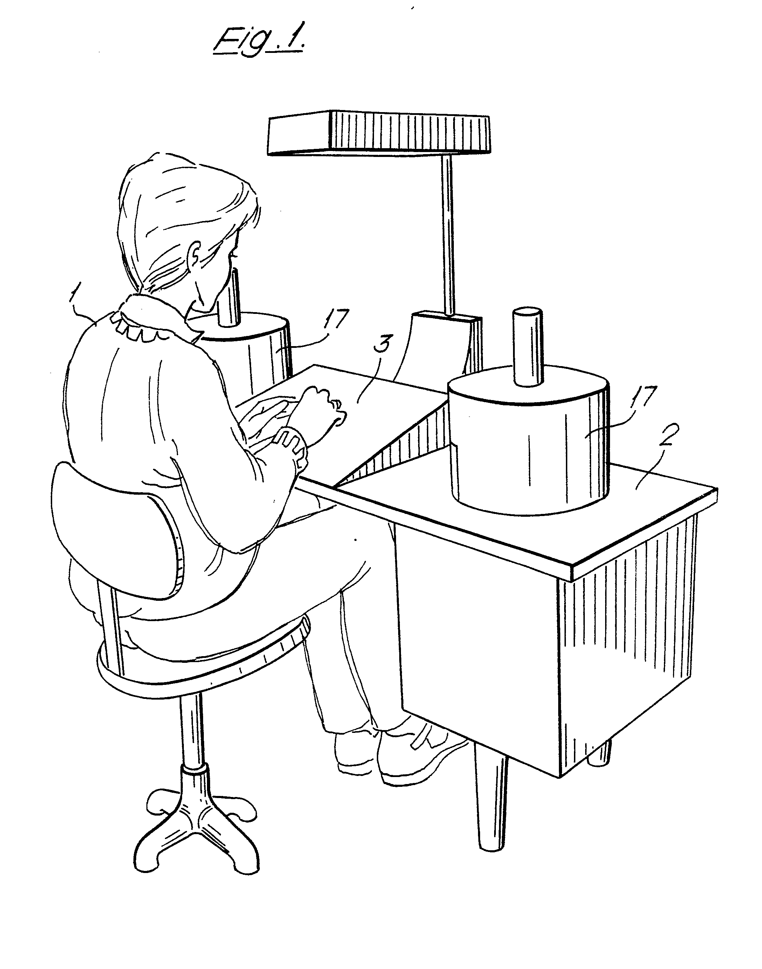

Referring to Figure 1, an operative 1 sits at a workbench 2 to assemble components on a front surface 3 of a printed circuit board under the guidance of apparatus embodying the invention which visually indicates to the operative the required location of each component on the printed circuit board and dispenses to the operative the particular component to be assembled at the indicated location.

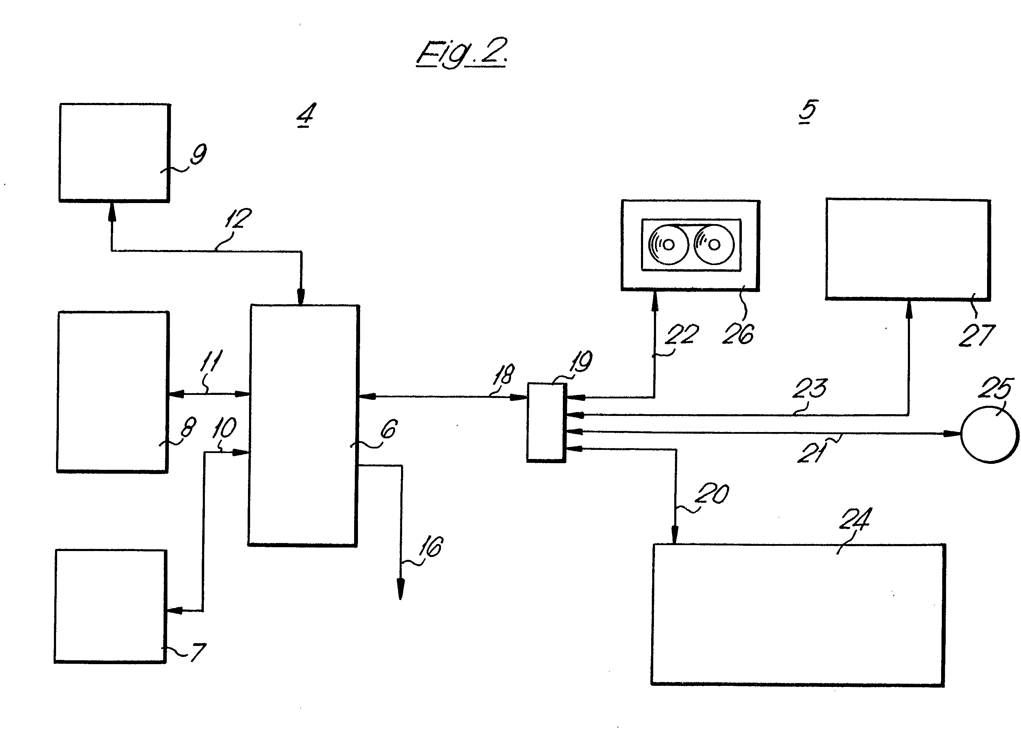

The apparatus embodying the invention is diagrammatically illustrated in Figure 2 and comprises a projection unit 4 and a separate programming unti 5. The projection unit 4 serves to project onto the front surface 3 of the circuit board a predetermined sequence of optical images of representations of electrical components to indicate to the operative the required sequence, position and orientation of components to be assembled on the board. To ensure that the operative adheres to the required assembly sequence, the projection unit also controls the operation of a component dispensing device to dispense to the operative only the particular component whose position and orientation is currently indicated by the projection unit. The programming unit 5 is used in conjunction with the projection unit to establish the initial data defining the desired assembly sequence for the assembly of a given printed circuit board and subsequently may be used to impart the same assembly data to other similar projection units.

The projection unit 4 comprises a processor 6 in the form of a microprocessor which is coupled to an electronic pattern library 7, an electronic memory 8 and a liquid crystal display unit 9 comprising a plurality of liquid crystals set out in a grid pattern or array and associated scan electronics to address a given liquid crystal, via respective bidirectional links 10, 11 and 12. The library 7 electronically stores a plurality of predetermined patterns which represent the shapes of various electrical components to be assembled on the printed circuit board and which include an indication of the polarity of the components. The memory 8 stores data defining the component assembly sequence for the given printed circuit board to be assembled.

The processor 6 uses the data stored in the library 7 and memory 8 to generate a video signal which is fed to the liquid crystal unit, the scan electronics associated therewith ensuring that the required liquid crystal or crystals are addressed and activated to form the required pattern representing a particular component in the liquid crystal unit 9.

The liquid crystal unit 9 is illuminated by light from a lamp 13, which lamp is placed at the focus of a mirror 56. The light thus produced passes through a condenser lens system 57, which ensures even illumination of the liquid crystal unit 9, and through the liquid crystal unit.

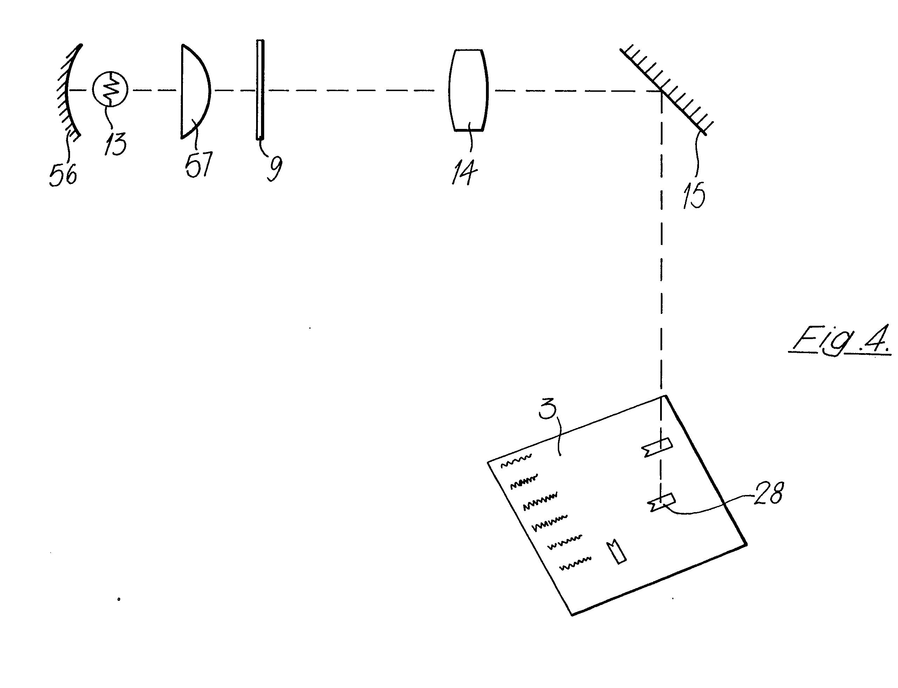

An optical projection system (shown in Figure 4) is included in the projection unit to project an image of the illuminated pattern formed in the liquid crystal unit 9 onto the front surface 3 of the printed circuit board 5. As shown in Figure 4, the optical projection system includes an imaging lens 14 and a mirror 15. The processor 6 also generates a control signal which is delivered on a control line 16 to a component dispensing device 17 shown schematically in Figure 1 and actuated by the control signal to dispense to the operative only the particular component whose position is indicated in each step of the assembly sequence.

The programming unit 5 is connectable to the projection unit by a plug-in bidirectional link 18 which connects the processor 6 to an interface 19 of the programming unit. Respective bidirectional links 20, 21, 22 and 23 connect the interface unit to a keyboard 24, a position control device 25 (which may be, for example, a joystick control or direction cursors formed by keys on a keyboard), a programme record and playback device 26 (which may, for example, be in the form of a magnetic tape cassette recording and playback machine or a solid state memory such as an EPROM for permanent or semi-permanent storage of a programme) and a printer 27. The keyboard 24 enables alpha-numeric information to be supplied to the processor 6 as data and instructions and includes a data entry key whereby data can be recorded in the memory 8. The position control device 25 generates a positioning signal which acts via the processor 6 to vary the position of a pattern formed in the liquid crystal unit 9 in dependence upon the position of the position control device. The programme record and playback device 26 may record information delivered to it from the processor 6 or may replay already recorded data to the processor 6. The printer may be employed to provide a visual copy of the information recorded in the programme record and playback device.

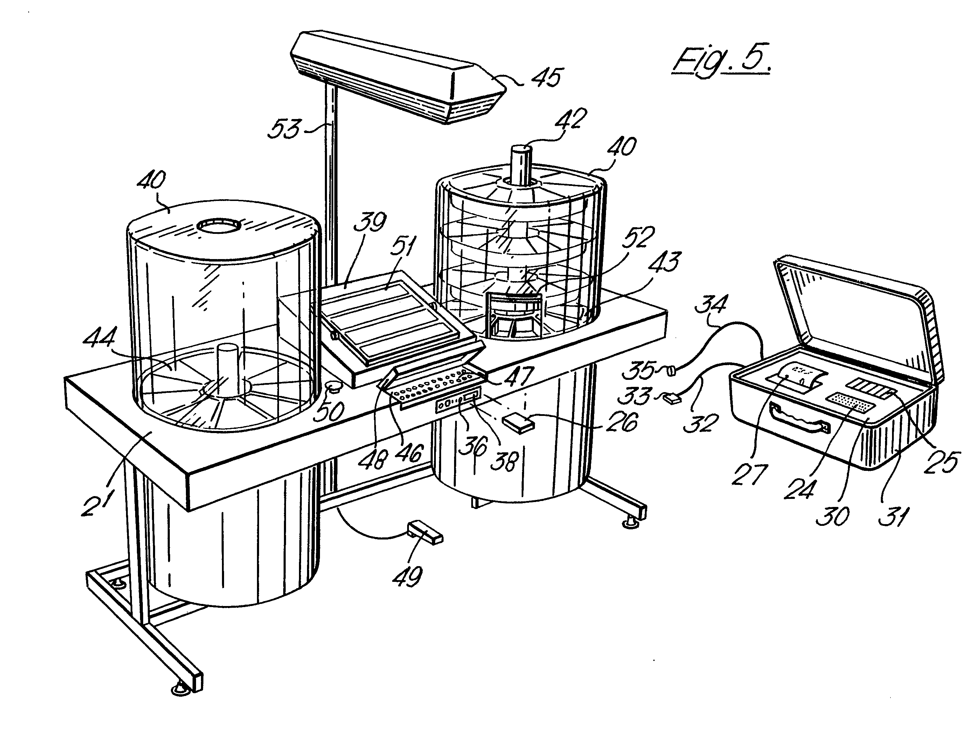

As shown in Figure 5, the keyboard 24, printer 27 and position control device 25 of the programming unit may be incorporated within a portable programmer 30 having a carrying case 31.

The programmer 30 has an input lead 32 with a socket 33 for connection to a power supply (not shown) and an output lead 34 having a connecting plug 35.

The workbench 2 is provided with a connection panel 36 internally connected to the interface 19 of the programming unit, both the interface 19 and the projection unit 4 being incorporated in the workbench 2. The connection panel 36 is formed with an input socket 10 for receiving the connecting plug 35 of the output lead and, adjacent the socket, with a recess 38 to accept a programme record and playback device in the form of a programme module such that both the programmer and the programme module can be connected via the interface 19 to the microprocessor 6.

The working surface 2' of the workbench 2 includes a centrally placed assembly surface 39 which is inclined with respect to the working surface 2' to facilitate assembly of components by an operative onto a printed circuit board place on a turnover fixture 51 mounted in the assembly surface. The turnover fixture 51 allows the underside of a complete circuit board to be inspected.

Dispenser bins 40 of the component dispensing device comprise two cylinders 41 extending through the working surface 2' on either side of the assembly surface 39. Each bin 40 has an axial shaft 42 onto which is fixedly mounted a number of spaced apart circular trays 43 each tray comprising individual sectorial compartments 44. A dispensing window 52 is formed in each cylinder 41 to allow an operative to remove a component from the compartment adjacent the window of a tray level with the working surface 2'.

Each shaft 42 is rotatably and axially movable, movement of each shaft being controlled by instructions received by the component dispenser device from the microprocessor 6 via control line 16.

In accordance with the instructions received, the component dispensing device may cause one or both of the shafts 42 to move axially thus raising or lowering the trays 43; an axially central circular aperture is formed in the uppermost circular surface of each cylinder to facilitate movement of the corresponding shaft. Alternatively, the component dispensing device may be instructed to rotate one or both shafts 42 causing a different compartment of the same tray to be brought into a position adjacent the associated dispensing window 52. Clearly, the above two operations may be combined to allow any compartment in any tray of dispenser bin to be selected.

Directly above but spaced apart from the assembly surface 39 is a projector 45 attached by means of a support post 53 to the workbench 2. The projector 45 houses the optical projection system, which may be as shown in Figure 4, and is arranged to project an image of the required size onto the inclined assembly surface 39.

Immediately in front of the assembly surface is a recessed operator panel 46 having an operator keyboard 47 and a cover 48, which cover in the closed position is flush with the working surface 2'. The keyboard 47 may allow an operative to inter alia, initiate operation of the projection unit, control the speed at which a sequence of assembly steps is projected, or reverse the projection sequence to check that a previously performed step has been executed correctly.

The projection unit is actuated by continuous pressure on a foot switch 49. In order that the system may be shut down quickly, an emergency stop button 50 is located adjacent the assembly surface 39.

In use of the described apparatus, the programming unit 5 is first used in conjunction with the projection unit to generate data defining the assembly sequence for a printed circuit board to be assembled. To this end, the printed circuit board is placed on the workbench 2 in the assembly position a programme module is inserted into recess 38 and the programmer 30 connected via input lead 32 to a power supply (not shown) and via output lead 34 through socket 37 and interface 19 to the projector system microprocessor 6.

Using the keyboard 24, the projection unit 4 is instructed to project onto the front surface 3 of a board on the assembly surface 39 the pattern corresponding to the first component to be assembled. The image of the projected pattern is then moved to the required location on the printed circuit board using the position control device 25 and, when the image is correctly positioned, the data entry key of keyboard 24 is actuated to store the identity of the projected pattern and the required position of the formation in the liquid crystal unit of the representation in the electronic memory 8. If only a single component is to be installed during the assembly step being recorded, the data block corresponding to this step is completed by recording further related information such as the type of component and its polarity, number and bin numbers, this also providing the necessary information to generate the control signal for the component dispensing device. The recorded information may further include details of the total number of steps, or frames, in the assembly sequence and the number of the assembly step just recorded. Figure 4 schematically shows an example of the information recorded for an assembly step.

If more than one component of the same type and value is to be installed on the printed circuit board during a given assembly step, then the component pattern is recalled from the library 7 the required number of times, the pattern being repositioned each time to correspond to another component position in the assembly step and each position being recorded when the pattern is correctly located. When the position of all the components to be installed in the assembly step have been recorded, then the data block corresponding to the assembly step is completed with the further information identifying the assembly step is completed with the further information identifying the assembly step and the component to be assembled during that step.

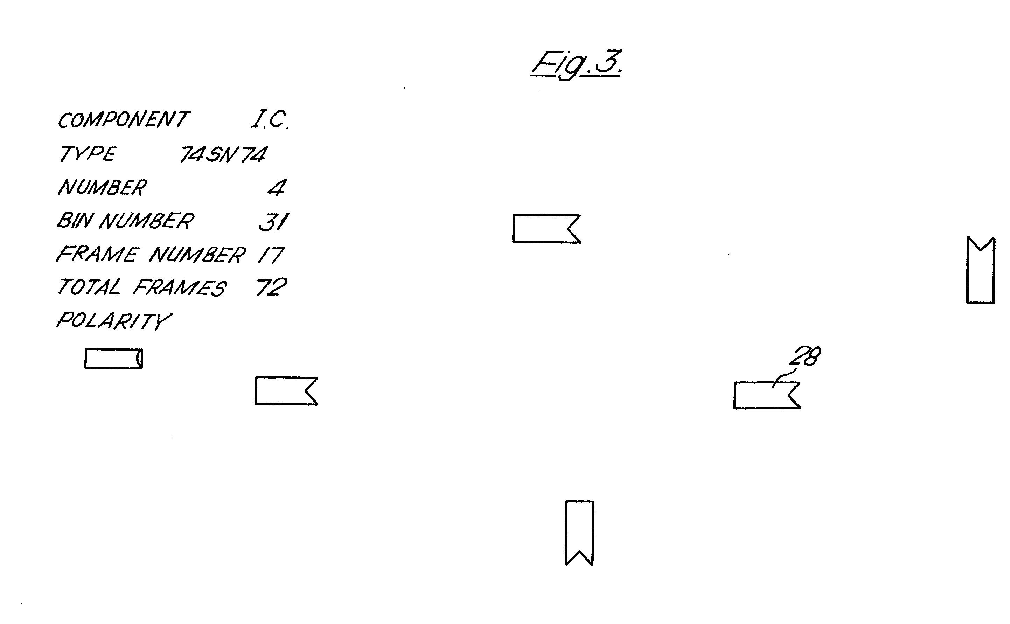

Figure 3 schematically illustrates the information recorded for an assembly step involving the assembly of a plurality of identical components in various positions and orientations on the board.

The procedure is then repeated for the succeeding steps of the assembly sequence and, once all the data relating to the complete assembly sequence has been recorded, the keyboard is actuated to transfer the recorded data from the electronic memory 8 of the projection unit to the programme record and playback device 26 contained in the recess 38 of the connection panel 36. The programming unit can then be used to record the same assembly data in the electronic memories of further projection units which are to be used in assembling the same printed circuit board.

Alternatively, the record and playback device in the form of the programme module shown in Figure 5 may be used interchangeably in different projection units.

Any changes which are found to be desirable in the assembly data can readily be effected by entering fresh data into the electronic memory 8 from the programming unit.

Once provided with the data relating to the assembly sequence, the projection unit can be run through the stored assembly sequence and produces, at each step of the sequence, an image of the component to be assembled at the required location on the printed circuit board. At the same time, the projection unit controls the component dispenser to deliver the corresponding component to the operative for assembly on the board at the indicated located. The operator panel may be provided with a key which overrides automatic projection of the assembly sequence such that after each assembly step has been completed the operative can instruct the projection unit to proceed to the next step by for example, depressing a given key of the control panel.

Figure 4 shows an example of an image projected onto the front surface 3 of a printed circuit board by the projection unit. In the example illustrated in Figure 4, three identical components are to be assembled during a particular assembly step, so that three identical component patterns 28 appear in the image at the three locations where the components are required to be installed.

It will be appreciated that the described apparatus embodying the invention unambiguously indicates the required location of components to the operative and ensures that the correct component is installed and the assembly is carried out in the correct sequence. The initial recording of the assembly program is easily and rapidly accomplished and any subsequent changes in the program can be incorporated speedily, with a single programming unit being sufficient to program a large number of projection units. Moreover, the described apparatus preserves the advantage of front projection systems in that it can be used to check an assembled printing circuit board.

CLAIMS:

1.      Apparatus for visually indicating to an operative the required location of a component to be assembled on a workpiece, which apparatus includes  a projection unit comprising a liquid crystal unit, means for generating a video signal for the liquid crystal unit to form therein a representation of the component at a position corresponding to the required location of the component on the workpiece surface and optical means for projecting an image of the representation formed in the liquid crystal unit on to the surface of the workpiece.

2.      Apparatus according to claim 1, wherein the signal-generating means comprises a pattern library for storing patterns which represent various kinds of component, a programme memory for storing data defining a sequence of component patterns and positions, and a processor connected to the pattern library and the programme memory for generating the required video signal from the stored pattern and programme data.

3.      Apparatus according to claim 1 or 2, wherein the liquid crystal unit is associated with light producing and condensing means to illuminate the image formed in the liquid crystal unit, which unit usually comprises an array of liquid crystals and associated scan electronics to address a given crystal.

4.      Apparatus according to any one of claims 1 to 3, wherein the projection unit also provides an electrical control signal for controlling a component dispensing device to dispense to the operative the particular component to be assembled at the location indicated by the component representation in the projected image.

5.      Apparatus according to any preceding claim, and further including a programming unit for programming the projector with data relating to a desired assembly sequence, which programming unit comprises means for supplying alpha-numeric data to the signal generating means to cause a desired component pattern to be formed in the liquid crystal unit and position control means for delivering a positioning signal to the signal generating means for varying the position of the displayed pattern in the liquid crystal unit to bring the pattern into a position corresponding to the desired location on the workpiece surface.

6. Apparatus according to claim 5, wherein the programming unit comprises recording and playback means for storing the programme generated by the programming unit.

7. Apparatus according to claim 5 or 6, wherein the programming unit comprises a printer to provide a hard copy of the generated programme.

8. Apparatus according to any one of claims 5 to 7, wherein the programming unit is detachable from the projection unit, so that a single programming unit may be used with a plurality of projection units.

9. A method of visually indicating to an operative the required location of a component to be assembled on a workpiece, which method comprises generating a video signal for a liquid crystal unit to form therein a representation of the component at a position corresponding to the required location of the component on a surface of the workpiece; and optically projecting an image of the representation formed in the liquid crystal unit onto the surface of the workpiece.

*Fig.1.*

# Fig.2.

# Fig.3.

COMPONENT      I.C.

TYPE        74SN74

NUMBER          4

BIN NUMBER      31

FRAME NUMBER  17

TOTAL FRAMES   72

POLARITY

28

_Fig.4._

0053501

Fig.5.